# EUROPEAN PATENT APPLICATION

(11) **EP 1 610 369 A1**
(43) Date of publication of application: **28.12.2005**
(21) Application number: 04722947.1
(22) Date of filing: 24.03.2004
(51) Int. Cl.: H01L 21/314, H01L 21/31

(54) **PLASMA FILM-FORMING METHOD AND PLASMA FILM-FORMING APPARATUS**

(30) Priority: 25.03.2003 JP 2003083292; 17.03.2004 JP 2004076958
(71) Applicant: TOKYO ELECTRON LIMITED, Minato-ku, Tokyo 107-8481 (JP)
(72) Inventor: KOBAYASHI, Yasuo c/o Tokyo Electron Limited, Nirasaki-shi, Yamanashi 4070192 (JP); KAWAMURA, Kohei c/o Tokyo Electron Limited, Nirasaki-shi, Yamanashi 4070192 (JP); ASANO, Akira c/o Tokyo Electron Limited, Nirasaki-shi, Yamanashi 4070192 (JP); TERAI, Yasuhiro c/o Tokyo Electron Limited, Nirasaki-shi, Yamanashi 4070192 (JP); NISHIZAWA, Kenichi c/o Tokyo Electron Limited, Nirasaki-shi, Yamanashi 4070192 (JP)
(74) Representative: Liesegang, Eva
(86) International application number: PCT/JP2004/004070
(87) International publication number: WO 2004/086483

(57) **Abstract**

A plasma-assisted deposition system for carrying out a plasma-assisted deposition method has a processing vessel defining a vacuum chamber and having an open upper end, a dielectric member covering the open upper end of the processing vessel, and a flat antenna member placed on the upper surface of the dielectric member. A coaxial waveguide has one end connected to the upper surface of the flat antenna member and the other end connected to a microwave generator. The flat antenna member is provided with many slots of a length corresponding to half the wavelength of a microwave arranged on concentric circles. For example, a circularly polarized microwave is radiated from the slots into a processing space to produce a source gas plasma. Electron temperature in the plasma in terms of mean square velocity is 3 eV or below and the electron density in the plasma is 5×10¹¹ electrons per cubic centimeter or above. The plasma is used for depositing a fluorine-containing carbon film. Preferably, the process pressure is 19.95 Pa or below. Under such process conditions for depositing a fluorine-containing carbon film by using the plasma, the source gas, such as C₅F₈ gas, is decomposed properly to form a structure of long CF chains. A interlayer insulation film thus formed has a small relative dielectric constant and permits only a low leakage current.

## Description

### TECHNICAL FIELD

The present invention relates to a plasma-assisted deposition method of depositing an insulating film, such as a fluorine-containing carbon film (fluorocarbon film), using a plasma and to a plasma-assisted deposition system.

### BACKGROUND ART

A multilevel wiring structure is one of methods of raising the level of integration of semiconductor devices. In a multilevel wiring structure, wiring layers on the nth and the (n+1)th layer are interconnected by conductors embedded in a thin film called a interlayer insulation film. A silicon dioxide film is a representative interlayer insulation film. The interlayer insulation film must have a small relative dielectric constant to increase the operating speed of the device.

Such circumstances take a great interest in the fluorine-containing carbon film. The relative dielectric constant of the fluorine-containing film is far smaller than that of the silicon dioxide film. A fluorine-containing film deposition method is disclosed in JP 11-162960 A (Patent document 1). According to Paragraphs 0016 to 0018 of the specification of JP-A 11-162960, cyclic C₅F₈ gas is used as a source gas, electron cyclotron resonance (ECR) is caused by the interaction of a 2.45 GHz microwave and a magnetic field of 875 G to produce a plasma of a plasma forming gas, such as Ar gas, ionizes C₅F₈ gas by the plasma to produce a plasma so that a fluorine-containing carbon film is deposited on a semiconductor wafer (hereinafter, referred to simply as "wafer").

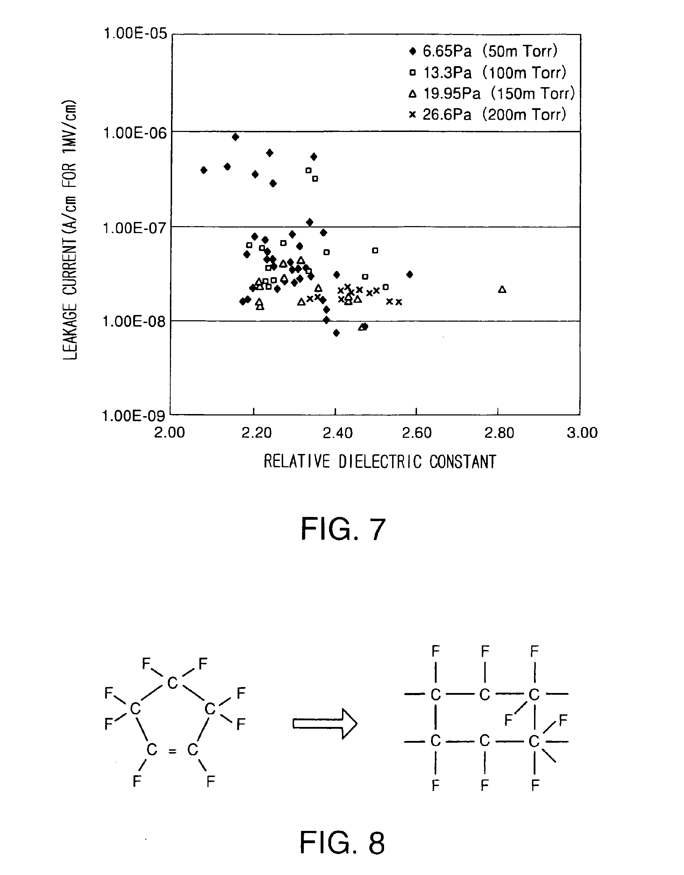

C₄F₈ gas is a known source gas. However, a film of three-dimensional structure as shown in Fig. 8 can be easily formed by decomposing C₅F₈. A interlayer insulation film of such three-dimensional structure has strong C-F bonds, a small relative dielectric constant, permits the flow of only a low leakage current, has a high strength and resistant to stress.

If the process pressure of a plasma-assisted deposition process is high, a reaction occurs in a gas phase, particles of a product produced by the reaction adhere to the wafer. It is feared that the particles adhering to the wafer fly in all directions while the wafer is being carried. The density of electrons in the plasma is low when the process pressure is high. Consequently, deposition rate decreases, the throughput of the process decreases to a level unsuitable for a mass production process. The process pressure, namely, the pressure of a processing atmosphere, must be lower than 100 Pa during the deposition process.

When the process pressure is low, the electron temperature of the plasma is high and the source gas is decomposed excessively. Consequently, small molecules are formed and a film of a composition greatly different from a desired composition is deposited, so that the composition and structure of the material cannot be effectively utilized. For example, when C₅F₈ gas is used as a source gas, small particles of a decomposition product deposit on the wafer in an amorphous film. Such an amorphous film does not have a small relative dielectric constant, and has electric characteristics permitting the flow of large leakage current, inferior mechanical characteristics, such as low strength and low stress resistance, and inferior chemical characteristics, such as low water resistance. For example, the advantage of C₅F₈ gas is its capability to form a three-dimensional chain structure of CF₂, namely, a fluorine-containing carbon film having a small relative dielectric constant and excellent mechanical characteristics. However, the best use of such an advantage of C₅F₈ gas has not been made until today. If the process pressure is raised, the electron temperature of the plasma decreases and the excessive decomposition of the source gas can be avoided. However, in this case, problems owing to particles and low deposition rate arises. Thus those parameters are incompatible with each other. The incompatibility of those parameters is one of factors that obstruct the formation of excellent fluorine-containing carbon films.

It is an object of the present invention to provide a method and a system capable of forming an insulating film having intrinsic molecular structure of a material by using a source gas plasma (a source gas activated by a plasma). Another object of the present invention to provide a film deposition method and a film deposition system capable of forming an insulating film having a low dielectric constant and excellent electric characteristics.

### DISCLOSURE OF THE INVENTION

A plasma-assisted deposition method in a first aspect of the present invention for forming an insulating film on a substrate placed on a support device in an airtight processing vessel by activating a source gas by a plasma characterized in that electron temperature in a plasma producing space extending between a source gas supply opening and a surface of the substrate in terms of mean square velocity is 3 eV or below and electron density in the plasma producing space is 5×10¹¹ electrons per cubic centimeter or above.

Since the electron temperature is 3 eV or below, the excessive decomposition of the source gas can be suppressed, and an insulating film having a molecular structure effectively utilizing the characteristics of the source gas, such as an insulating film having a small relative dielectric constant and excellent electric characteristics, can be deposited.

In the plasma-assisted deposition method in the first aspect of the present invention, a microwave is guided to a flat antenna member disposed opposite to the support device by a waveguide, and the microwave is radiated from a plurality of slots formed in a circumferential arrangement in the flat antenna member to activate the source gas by the energy of the microwave.

In the plasma-assisted deposition method in the first aspect of the present invention, the slots have a length between half the wavelength of the microwave at the side of the waveguide with respect to a part of the flat antenna member and half the wavelength of the microwave at the side of the plasma producing space with respect to a part of the flat antenna member.

In the plasma-assisted deposition method in the first aspect of the present invention, the plurality of slots are arranged on concentric circles having their centers at the center of the flat antenna member or on a spiral around the center of the flat antenna member.

In the plasma-assisted deposition method in the first aspect of the present invention, the microwave radiated from the flat antenna member is a circularly polarized wave or a linearly polarized wave.

In the plasma-assisted deposition method in the first aspect of the present invention, the pressure of a processing atmosphere is 19.95 Pa or below.

When the pressure in the processing vessel is 19.95 Pa (150 mTorr) or below, an insulating film having a small relative dielectric constant and excellent electric characteristics can be deposited by selectively determining process conditions.

In the plasma-assisted deposition method in the first aspect of the present invention, the insulating film to be deposited on the substrate is a fluorine-containing carbon film.

In the plasma-assisted deposition method in the first aspect of the present invention, the source gas is C₅F₈ gas.

A plasma-assisted deposition system in a second aspect of the present invention comprising: an airtight processing vessel internally provided with a support device for supporting a substrate thereon; a source gas supply system for supplying a source gas for forming an insulating film on the substrate into the processing vessel; a microwave generator for generating a microwave for activating the source gas to produce a plasma; a waveguide for guiding the microwave generated by the microwave generator into the processing vessel; and a flat antenna member provided with a plurality of slots formed therein in a circumferential arrangement; characterized in that electron temperature in a plasma producing space extending between a source gas supply opening and a surface of the substrate in terms of mean square velocity is 3 eV or below and an electron density in the plasma producing space is 5×10¹¹ electrons per cubic centimeter or above.

In the plasma-assisted deposition system in the second aspect of the present invention, the slots have a length between half the wavelength of the microwave at the side of the waveguide with respect to a part of the flat antenna member and half the wavelength of the microwave at the side of the plasma producing space with respect to a part of the flat antenna member.

In the plasma-assisted deposition system in the second aspect of the present invention, the plurality of slots are arranged on concentric circles having their centers at the center of the flat antenna member or on a spiral around the center of the flat antenna member.

In the plasma-assisted deposition system in the second aspect of the present invention, the microwave radiated from the flat antenna member is a circularly polarized wave or a linearly polarized wave.

In the plasma-assisted deposition system in the second aspect of the present invention, the insulating film to be deposited on the substrate is a fluorine-containing carbon film.

In the plasma-assisted deposition system in the second aspect of the present invention, the source gas is C₅F₈ gas.

### BRIEF DESCRIPTION OF THE DRAWINGS

Fig. 1 is a schematic longitudinal sectional view of a plasma-assisted deposition system in a preferred embodiment according to the present invention;
Fig. 2 is a plan view of a second gas supply device included in the plasma-assisted deposition system shown in Fig. 1;
Fig. 3 is a partly cutaway perspective view of an antenna unit included in the plasma-assisted deposition system shown in Fig. 1;
Fig. 4 is a plan view of the flat antenna unit included in the plasma-assisted deposition system shown in Fig. 1;
Fig. 5 is a graph showing the relation between the number of electrons and electron temperature for defining electron temperature;
Fig. 6 is a graph showing the dependence of intensity of leakage current on the relative dielectric constant of an insulating film determined through experiments;
Fig. 7 is a graph showing the dependence of intensity of leakage current on the relative dielectric constant of an insulating film determined through experiments; and'
Fig. 8 is a diagram showing the molecular structure of a source gas and that of an insulating film.

### BEST MODE FOR CARRYING OUT THE INVENTION

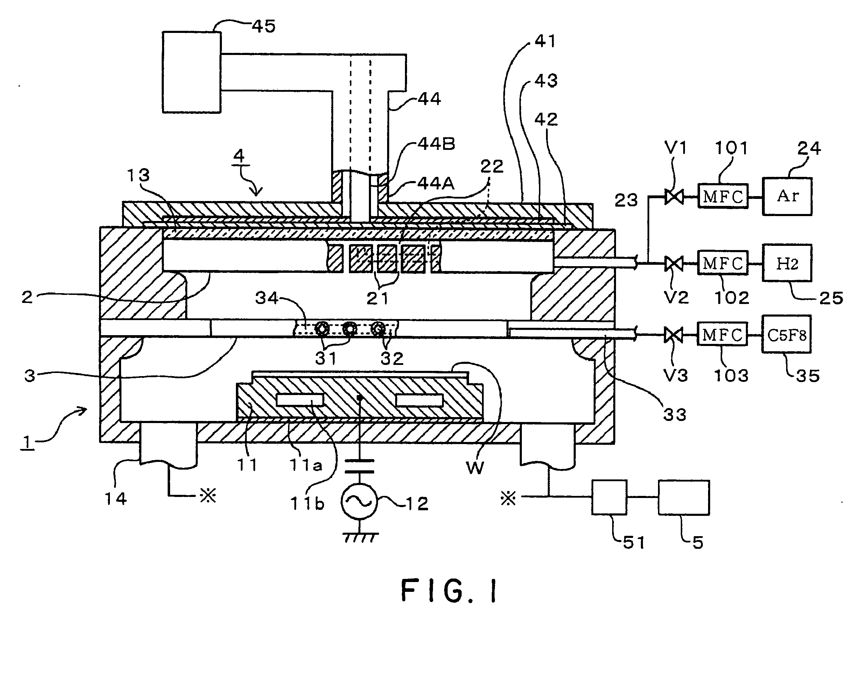

A plasma-assisted deposition system in a preferred embodiment according to the present invention will be described with reference to Figs. 1 to 7. Referring to Fig. 1, the plasma-assisted deposition system is a CVD system (chemical vapor deposition system) using a radial line slot antenna for producing a plasma. A processing vessel (a vessel forming a vacuum chamber) 1 has a generally cylindrical shape. The side wall and the bottom wall of the processing vessel 1 are made of, for example, an Al-containing stainless steel. The inside surfaces of the processing vessel 1 is coated with a protective film of aluminum oxide.

A support table 11 for supporting a substrate, such as a wafer W is disposed in a substantially central part of the bottom wall of the processing vessel 1. An insulating sheet 11a is interposed between the support table 11 and the bottom wall of the processing vessel 1. The support table 11 is made of, for example, aluminum nitride (AIN) or aluminum oxide (Al₂O₃). The support table 11 is provided with a coolant passage 11b through which a coolant flows. A heater, not shown, for heating the support table 11 is embedded in the support table 11. An electrostatic chuck is formed on the upper surface of the support table 11. A high-frequency power source 12 for generating a bias high-frequency power of, for example, 13.56 MHz is connected to the support table 11. A bias high-frequency power is applied to charge the surface of the support table at a negative potential so that ions of a plasma can be attracted to the support table in high perpendicularity to the surface of the support table 11.

The processing vessel 1 has an open upper end. A first gas discharge head 2 substantially circular in a plane is placed in the open upper end of the processing vessel 1 opposite to the support table 11. A sealing member, not shown, such as an O ring, is placed between the upper end of the processing vessel 1 and the first gas discharge head 2. The first gas discharge head 2 is made of, for example, Al₂O₃ and is provided many first gas discharge holes 21 opening in a surface thereof facing the support table 11. A gas passage 22 is formed in the gas discharge head 2 so as to connect to the first gas discharge holes 21. A first gas supply line 23 has one end connected to the gas passage 22 and the other end connected to a plasma gas source 24 for supplying a plasma gas, such as Ar gas or Kr gas and a hydrogen gas source 25 for supplying H₂ gas. The first gas supply line 23 carries the gases into the gas passage 22. The gases are discharged through the gas discharge holes 21 and are distributed uniformly in a space extending under the first gas discharge head 2. In this embodiment, the distance between the lower surface of the first gas discharge head 2 and a surface of a wafer W supported on the support table 11 is 50 mm.

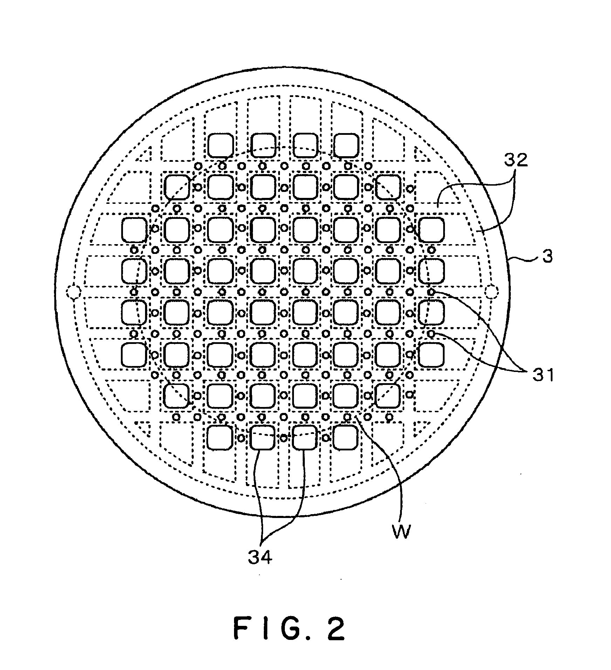

A second gas discharge head 3 is disposed between the support table 11 and the first gas discharge head 2 in the processing vessel 1 so as to divide a space between the support table 11 and the first gas discharge head 2 into upper and lower spaces. The second gas discharge head 3 has, for example, a flat, substantially circular shape and is made of a conducting material, such as a Mg-containing Al alloy or an Al-containing stainless steel. The second gas discharge head 3 is provided in its surface facing the support table 11 with many second gas discharge holes 31. Gas passages 32 are formed, for example, in a grid inside the second gas discharge head 3 as shown in Fig. 2. The second gas discharge holes 31 communicate with the gas passages 32. The gas passages 32 are connected to one end of a second gas supply line 33. The second gas discharge head 3 is provided with many through holes 34. A plasma and a source gas dispersed in the plasma flow from the upper space over the second gas discharge head 3 through the through holes 34 into the lower space under the second gas discharge head 3. The through holes 34 are formed, for example, between adjacent gas passages 32.

The second gas supply line 33 connects the second gas discharge head 3 to a source gas source 35 that supplies a source gas containing fluorine and carbon, such as C₅F₈. The second gas supply line 33 carries the source gas into the gas passages 32. The source gas is discharged through the gas discharge holes 31 into the lower space under the second gas discharge head 3 to distribute the source gas uniformly in the lower space. In Fig. 1, indicated at V1 to V3 are valves and at 101 to 103 are flow regulators.

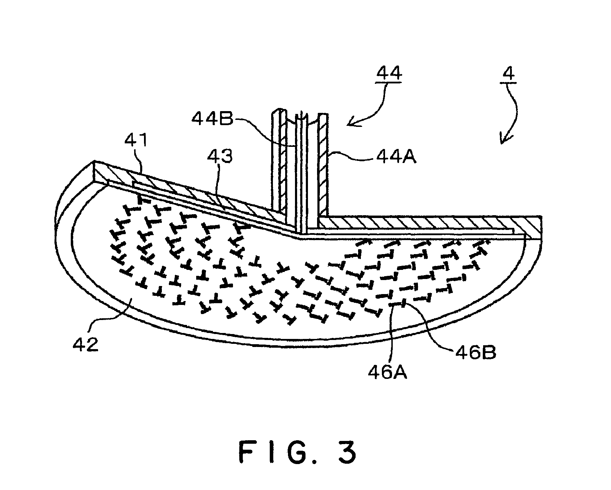

A cover plate 13 made of a dielectric material, such as Al₂O₃, is put on the first gas discharge head 2 with a sealing ember, not shown, such as an O ring, held between the cover plate 13 and the first gas discharge head 2. An antenna 4 is placed in close contact with the upper surface of the cover plate 13. As shown in Fig. 3, the antenna 4 has an antenna body 41 of a flat, circular shape having an open lower end, and a circular, flat antenna member 42 provided with many slots (slot plate). The flat antenna member 42 is fitted in a recess formed in the open lower end of the antenna body 41. The antenna body 41 and the flat antenna member 42 are made of a conducting material. Thus the antenna body 41 and the flat antenna member 42 constitute a flat, hollow circular waveguide.

A lagging plate 43 made of a low-loss dielectric material, such as Al₂O₃, SiO₂ or Si₃N₄ is sandwiched between the antenna body 41 and the flat antenna member 42. The lagging plate 43 shortens the wavelength of a microwave to shorten the wavelength in the waveguide. In this embodiment, the antenna body 41, the flat antenna member 42 and the lagging plate 43 constitute a radial line slot antenna.

The antenna 4 is placed with the flat antenna member 42 in close contact with the cover plate 13 with a sealing member, not shown, held between the cover plate 13 and the flat antenna member 42. The antenna 4 is connected to an external microwave generator 45 by a coaxial waveguide 44. A microwave of 2.45 GHz or 8.3 GHz is transmitted to the antenna 4. The coaxial waveguide 44 has an outer waveguide 44A and a central conductor 44B. The outer waveguide 44A is connected to the antenna body 41 and the central conductor 44B is passed through a through hole formed in the lagging plate 43 and is connected to the flat antenna member 42.

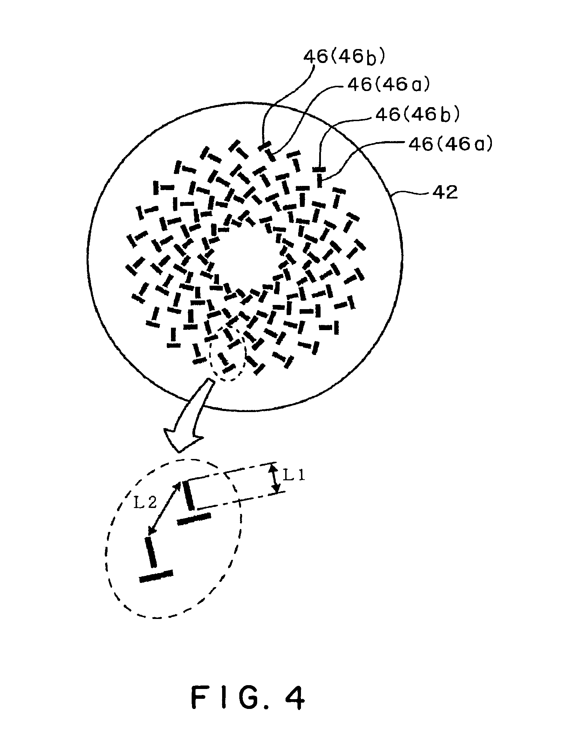

The flat antenna member 42 is a copper plate of a thickness, for example, on the order of 1 mm. As shown in Figs. 3 and 4, the flat antenna member 42 is provided with many slots 46 for generating, for example, a circularly polarized wave. The slot 46 is a pair of slot 46a and slot 46b combined in T-shaped slot set so that the slots 46a and 46b are spaced a short distance apart. The T-shaped slot sets are arranged on concentric circles or a spiral. Since the slots 46a are perpendicular to their corresponding slots 46b, the antenna 4 radiates a circularly polarized wave having two perpendicularly intersecting wave components.

The T-shaped slot sets each consisting of the slots 46a and 46b are arranged at intervals corresponding to the wavelength of the microwave compressed by the lagging plate 43 on concentric circles having their centers at the center of the flat antenna member 42 or a spiral around the center of the flat antenna member 42. Therefore, the flat antenna member 42 radiates a substantially plane microwave. The slots 46a and 46b are formed in a length L1 between half the wavelength of the microwave on the side of the waveguide 44 with respect to the flat antenna 42 and half the wavelength of the microwave on the side of a plasma producing space with respect to the flat antenna 42; that is the length L1 of the slots 46a and 46b is not longer than half the wavelength of the microwave on the side of the coaxial waveguide 44 with respect to the flat antenna 42 and longer than the wavelength of the microwave on the side of the plasma producing space, i.e., a space in the processing vessel 2, with respect to the antenna member 42. Thus the microwave is able to propagate through the slots 46 into the plasma producing space and unable to propagate back from the plasma producing space into the coaxial waveguide 44. When the slots 46 are arranged on concentric circles, the distance L2 between the slot 46 on an inner circle and the slot 46 on an outer circle adjacent to the inner circle is, for example, equal to half the wavelength of the microwave on the side of the coaxial waveguide 44

An exhaust pipe 14 provided with a pressure regulator 51 has one end connected to the bottom wall of the processing vessel 1 and the other end connected to a vacuum pump, namely, an evacuating means. The vacuum pump can evacuate the processing vessel 1 at a predetermined vacuum.

A film deposition method to be carried out by this plasma-assisted deposition system will be described by way of example. A wafer W, namely, a substrate, provided with aluminum wiring lines on a surface thereof is carried through the gate valve into the processing vessel 1. The wafer W is placed on the support table 11. Then, the processing vessel 1 is evacuated to a predetermined vacuum. Subsequently, a plasma gas, such as Ar gas, is supplied to the first gas discharge head 2 through the first gas supply line 23 at a flow rate of, for example, 300 sccm, and a source gas, such as C₅F₈ gas, is supplied to the second gas discharge head 3 through the second gas supply line 33 at a predetermined flow rate of, for example, d150 sccm. The interior of the processing vessel 1 is kept at a precess pressure of, for example, 13.3 Pa and the support table 11 is heated to a surface temperature of 350°C.

The microwave generator generates a high-frequency wave, namely, a microwave, of 2.45 GHz and 2000 W. The microwave propagates in the coaxial waveguide 44 in the TM, the TE or the TEM mode to the flat antenna member 42 of the antenna 4. Then, the microwave propagates through the central conductor 44B to a central part of the flat antenna member 42 and propagates radially from the central part of the flat antenna member 42 toward the circumference of the flat antenna member 42. While the microwave thus propagates radially, the microwave radiates from the slots 46a and 46b, propagates through the cover plate 13 and the first gas discharge head 2. Then the microwave is radiated into the processing space under the first gas discharge head 2. The cover plate 13 and the first gas discharge head 2 made of a material capable of transmitting the microwave, such as Al₂O₃ serve as a microwave transmission window. The microwave penetrates the cover plate 13 and the first gas discharge head 2 efficiently.

Since the slots 46a and 46b are arranged in the arrangement mentioned above, the circularly polarized wave is radiated uniformly from the flat antenna member 42 and creates an electric field having a uniform electric-field distribution. A uniform, high-density plasma is produced over the entire processing space by the energy of the microwave. The plasma flows through the through holes 34 of the second gas discharge head 3 into the processing space under the second gas discharge head 3. The plasma activates the C₅F₈ gas discharged from the second gas discharge head 3 to produce active species. The C₅F₈ gas plasma (the C₅F₈ gas activated by the plasma) has a low electron temperature of, for example, 1.2 eV. Sine the process pressure is low, the plasma has an electron density on the order of 10¹² electrons per cubic centimeter.

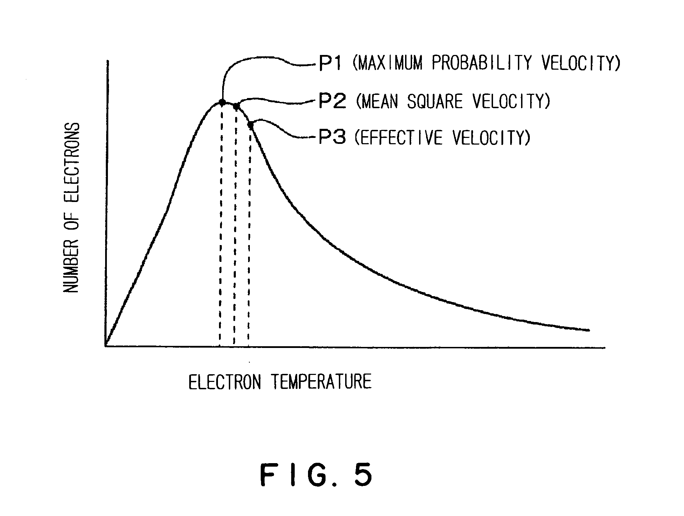

Electron temperature is defined in terms of mean square velocity. Any measuring means may be used for measuring electron temperature. A measuring point for measuring electron temperature is in a space between the gas discharge hole 31 of the second gas discharge head 3 and the wafer W and is not in spaces near the wall of the processing vessel 1 and below the circumference of the support table 11. Electron temperature is defined in terms of mean square velocity on an assumption that the relation between electron temperature and the number of electrons can be represented by a Maxwell-Boltzmann distribution as shown in Fig. 5. Electron temperature is the mean of the sum of squares of the numbers of electrons. Indicated at P1, P2 and P3 in Fig. 5 are maximam probability velocity, mean square velocity and effective velocity, respectively.

Although the reason a plasma having a high electron density and a low electron temperature together is not clearly grasped, it is inferred that electrons follow up the electric field satisfactorily when the source gas is activated to produce a plasma by the microwave radiated through the circumferential slots 46 of the flat antenna member 42. If the performance of electrons to follow up the electric field is unsatisfactory, the field intensity of the electric field needs to be increased. However, it is inferred that the source gas can be activated without increasing the field intensity of the electric field and only few electrons come off the electric field, collide against the wall of the processing vessel 1 and disappear when electrons follow up the electric field satisfactorily.

Active species reached the surface of the wafer W deposit in a CF film on the wafer W. The sputter etching effect of Ar ions attracted to the wafer W by the bias voltage for attracting the ions of the plasma etches off a CF film deposited on corners of lines of a pattern formed on the surface of the wafer W, expands openings and deposits CF films in recesses in the pattern to fill up the recesses with the CF film. The wafer W coated with the CF film is carried out of the processing vessel through the gate valve, not shown.

The plasma-assisted deposition system in this embodiment forms the insulating film by plasma having the high electron density and a low electron temperature. The CF film thus formed has satisfactory electric characteristics including a small relative dielectric constant and capability of suppressing leakage current. It is inferred that such a CF film having satisfactory electric characteristics can be formed because all the cyclic bonds of C₅F₈ gas, namely, a source gas, are not broken by excessive decomposed, only some of the cyclic bonds of C₅F₈ gas are broken, and the broken C₅F₈ molecules link together to form a three-dimensional structure of long CF chains. Thus the CF film has molecular bonds intrinsic to the composition of the source gas. The CF film has excellent mechanical characteristics including high strength and high stress resistance, and excellent chemical characteristics including high water resistance. Since the plasma keeps a high electron density, the deposition rate will not decrease a level unsuitable for a mass production process.

A source gas other than C₅F₈ gas may be used for forming the CF film. Possible source gases are, for example, C₃F₆ gas, C₄F₆ gas and C₄F₈ gas. The insulating film to be formed by the present invention is not limited to the CF film; the insulating film may be a SiOF film, namely, a film of a compound of silicon, oxygen and fluorine. Those insulating films, other than the CF film, having excellent electric characteristics and molecular bonds intrinsic to the composition of the source gas can be formed.

The slots 46a and 46b of the flat antenna member 42 do not necessarily need to be combined in the substantially T-shaped slot sets. The flat antenna member 42 may be provided with slots formed and arranged so as to radiate a linearly polarized microwave instead the circularly polarized microwave. The present invention may be embodied in ECR plasma deposition systems, parallel-plate plasma deposition systems and inductively coupled plasma deposition systems capable of producing a plasma having an electron density of 5×10¹¹ electrons per cubic centimeter or above and an electron temperature of 3eV or below for depositing an insulating film.

### Experiment 1

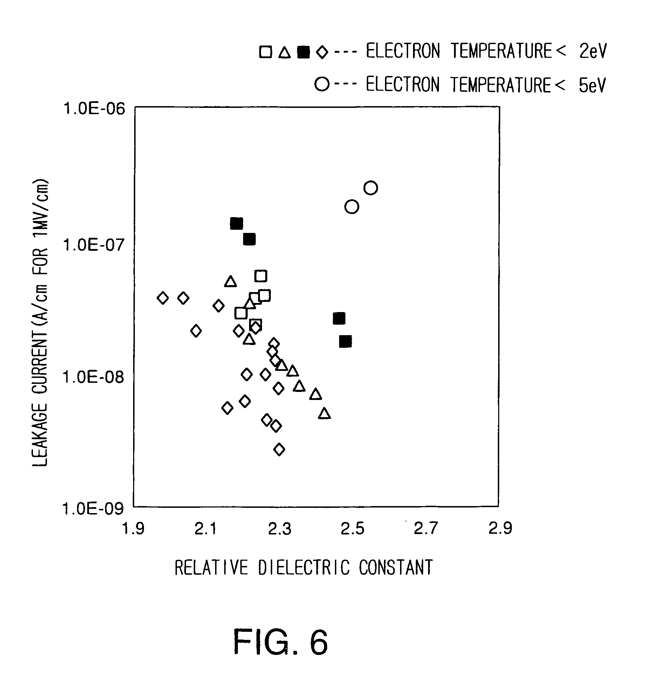

CF films were formed under various process conditions by the plasma-assisted deposition system shown in Fig. 1 and various source gases. The relative dielectric constants of the CF films and leakage currents flowed through the CF films were measured. Fig. 6 shows the measured results. In Fig. 6, leakage current is represented on the vertical axis and relative dielectric constant is represented on the horizontal axis. An electric field of 1 MV/cm was applied to the insulating film and leakage current flowed through the insulating film was measured. The inventors obtained a mass of data on source gases through experiments, only the typical data is shown in Fig. 6 because the data are analogous.

In Fig. 6, blank squares indicate data on the CF films formed by using C₃F₆ gas, blank triangles indicate data on the CF films formed by using C₄F₆ gas, solid squares indicate data on the CF films formed by using C₄F₈ gas and blank rhombuses indicate data on the CF films formed by using C₅F₈ gas. The process pressure was varied in the range of 6.65 to 19.95 Pa (50 to 150 mTorr), the high-frequency power was varied in the range of 1500 to 3000 W, the flow rate of Ar gas was varied in the range of 100 to 500 sccm, the flow rate of the source gas was varied in the range of 50 to 200 sccm, and the distance between the wafer W and the lower surface of the second gas discharge head 3 was varied in the range of 40 to 105 mm to produce a plasma having an electron temperature of 2 eV or below. Hydrogen gas was used in combination with C₃F₆ gas or C₄F₈ gas.

Electron temperature was preliminarily measured in a space between the source gas discharge holes and the wafer with a Langmuir probe. Electron temperature defined by mean square velocity was in the range of 1.1 to 2.0 eV. Since the process pressure is in the low process pressure range of 6.65 to 19.95 Pa (50 to 150 mTorr), electron density was on the order of 10¹² electrons per cubic centimeter. Electron density was confirmed by measurement using a Langmuir probe. As a Method of measuring electron temperature and electron density during a film is deposited under certain process conditions using C₃F₆ gas and the like as a source gas, Ar gas plasma (Ar gas activated by plasma) under the same process conditions was used instead of the source gas plasma and measured the electron temperature and the electron density of the plasma with a Langmuir probe. Thus, Ar gas was used to determine electron temperature and electron density because there is the possibility that a CF gas corrodes the Langmuir probe. Values of electron temperature and electron density are substantially the same for different gases and hence there is no problem in the method of evaluation.

Process conditions for forming the CF films respectively having relative dielectric constants in the range of 1.9 to 2.1 represented by the data indicated by three blank rhombuses will be described. The process pressure was 13.3 Pa (100 mTorr), the high-frequency power is 2000 W, the flow rate of Ar gas is 300 sccm, the flow rate of the source gas is 100 sccm, the distance between the wafer W and the lower surface of the flat antenna member is 50 mm and electron temperature is 1.1 eV. Data shown herein is the mean of measured data on three parts of the wafer.

Blank circles indicate data on CF films formed by the ECR plasma deposition system mentioned in Patent document 1 using C₅F₈ gas and a plasma having an electron temperature in the range of 5 to 6 eV.

An excellent interlayer insulation film must have a small relative dielectric constant and must be permitting only a low leakage current. The inventors of the present invention intend to provide interlayer insulation films having a relative dielectric constant of 2.2 or below and permitting a leakage current of 10⁻⁸ A/cm² or below. As obvious from Fig. 6, the CF film has a large relative dielectric constant of 2.5 or above and permits a high leakage current of 10⁻⁷ A/cm² when the electron temperature is higher than 5 eV. The large relative dielectric constant and the high leakage current are outside desired ranges. When the electron temperature is 2 eV or below, the CF film has a small relative dielectric constant or permits only a low leakage current, or the small relative dielectric constant and the low leakage current. And characteristics of CF films are near the desired ranges.

It is clearly known from this data that data on CF films formed at an electron temperature between 2 and 3 eV, as compared with data on CF films formed at an electron temperature of 5 eV, lie in lower left-hand region of the graph shown in Fig. 6 and that the CF films have a small relative dielectric constant and permits only a low leakage current. Thus, the data substantiates that excessive decomposition of the source gas can be suppressed and a CF film of molecular structure intrinsic to the composition of the source gas can be formed when the electron temperature is 3 eV or below. For example, when C₅F₈ gas is used, data on the CF film lies near the desired ranges and it is inferred that CF bonds of C₅F₈ gas are properly broken, the broken C₅F₈ molecules link together to form a three-dimensional structure of long CF chains and the CF film is an insulating film having a small relative dielectric constant and permitting only a low leakage current. When the electron temperature is higher than 5 eV, C₅F₈ gas is completely decomposed and desired chain structure cannot be formed.

Data on CF films formed by using plasmas having an electron density lower than 5×10¹¹ electrons per cubic centimeter was not obtained. When the conventional ECR plasma deposition system is used in an ordinary manner, electron temperature can be decreased by increasing pressure, but electron density decreases when pressure is increased. The present invention specifies an electron density to discriminate plasma-assisted deposition method of the present invention from such a plasma-assisted deposition method. It is known experientially that a film can be deposited at a sufficiently high deposition rate when the electron density is 5×10¹¹ electrons per cubic centimeter or above with the dissociation of the source gas. The present invention is premised on this condition and carries out a deposition process using a low electron temperature.

### Experiment 2

CF films were formed under various process conditions by the plasma-assisted deposition system shown in Fig. 1 using C₅F₈ gas as a source gas for pressures of processing atmosphere (process pressures) of 6.65 Pa (50 mTorr), 13.3 Pa (100 mTorr), 19.95 Pa (150 mTorr) and 26.6 Pa (200 mTorr). The relative dielectric constants of the CF films and leakage currents flowed through the CF films were measured. Fig. 7 shows the measured results. In Fig. 7, leakage current is represented on the vertical axis and relative dielectric constant is represented on the horizontal axis. An electric field of 1 MV/cm was applied to the insulating film and leakage current flowed through the insulating film was measured. The process conditions are the distance between the second gas discharge head 3 and the wafer (Fig. 1), high-frequency power, the flow rate of Ar gas, the flow rate of the source gas and the temperature of the wafer. CF films were deposited by using various combinations of the process conditions for a fixed process pressure.

As obvious from Fig. 7, leakage current and relative dielectric constant change in a wide range when the process conditions are changed. For example, some CF film deposited at a process pressure of 13.3 Pa is superior to some CF film deposited at a process pressure of 26.6 Pa in both leakage current and relative dielectric constant; that is, the relative dielectric constant of the former CF film is smaller than that of the latter CF film, and the leakage current of the former CF film is lower than that of the latter CF film. Some other CF film deposited at a process pressure of 13.3 Pa is inferior to some other CF film deposited at a process pressure of 26.6 Pa in both leakage current and relative dielectric constant. Since CF films having a better insulating ability permit a lower leakage current and have a smaller relative dielectric constant, data in a lower left-hand regions of the graph shown in Fig. 7 indicate insulating films having better characteristics.

It is known through the examination of the experimental results shown in Fig. 7 with reference to the results of Experiment 1 that both leakage current and relative dielectric constant are dependent on process conditions including process pressure, the data changes according to the change of process conditions even if process pressure is fixed, and the range of spread of the data is dependent on the magnitude of process pressure. That is, although data can be brought near a lower left-hand region of the graph shown in Fig. 7 by properly determining process conditions, the mode of approach of data to the lower left-hand region is dependent on the magnitude of process pressure. When the process pressure is 19.95 Pa or below, relative dielectric constant is about 2.2 and leakage current is about 10⁻⁸ A/cm². When process pressure is 26.6 Pa, relative dielectric constant cannot be decreased below 2.3.

The dependence of leakage current and relative dielectric constant on process conditions will be described. There is a tendency that leakage current decreases as the temperature of the wafer is decreased, and that relative dielectric constant decreases as the distance between the second gas discharge head 3 and the wafer is shortened. To deposit CF films having properties represented by data distributed in a lower left-hand region of the graph shown in Fig. 7, considerate selection of process conditions including the flow rates of gases is important. Thus it is known that it is desirable to use a process pressure of 19.95 Pa (150 mTorr) or below to form an insulating film having satisfactory characteristics when the electron temperature is 3 eV or below, preferably, 2 eV or blow and the electron density is 5×10¹¹ electrons per cubic centimeter or above in the plasma. It is insignificant to determine a lower limit process pressure. A lower process pressure may be used if such a process pressure can be achieved by a vacuum pump having a high evacuation capacity. As obvious from the data shown in Fig. 6, an electron temperature used for depositing the CF films having a relative dielectric constant of 2.3 or below and measured a leakage current of 5×10⁻⁸ A/cm² or below represented by data shown in Fig. 7 is 2 eV or below.

## Claims

1. A plasma-assisted deposition method for forming an insulating film on a substrate placed on a support device in an airtight processing vessel by activating a source gas by a plasma **characterized in that** a plasma producing space extending between source gas supply openings and a surface of the substrate has an electron temperature of 3 eV or below in terms of mean square velocity and an electron density of 5×10¹¹ electrons per cubic centimeter or above.

2. The plasma-assisted deposition method according to claim 1, wherein a microwave is guided to a flat antenna member disposed opposite to the support device by a waveguide, and the microwave is radiated from a plurality of slots formed in a circumferential arrangement in the flat antenna member to activate the source gas by the energy of the microwave.

3. The plasma-assisted deposition method according to claim 2, wherein the slots have a length between half the wavelength of the microwave at the side of the waveguide with respect to the flat antenna member and half the wavelength of the microwave at the side of the plasma producing space with respect to the flat antenna member.

4. The plasma-assisted deposition method according to claim 2 or 3, wherein the plurality of slots are arranged on concentric circles having their centers at the center of the flat antenna member or on a spiral around the center of the flat antenna member.

5. The plasma-assisted deposition method according to any one of claims 2 to 4, wherein the microwave radiated from the flat antenna member is a circularly polarized wave or a linearly polarized wave.

6. The plasma-assisted deposition method according to any one of claims 1 to 5, wherein the pressure of a processing atmosphere is 19.95 Pa or below.

7. The plasma-assisted deposition method according to any one of claims 1 to 6, wherein the insulating film to be deposited on the substrate is a fluorine-containing carbon film.

8. The plasma-assisted deposition method according to claim 7, wherein the source gas is C₅F₈ gas.

9. A plasma-assisted deposition system comprising:
an airtight processing vessel internally provided with a support device for supporting a substrate thereon;
a source gas supply system for supplying a source gas for forming an insulating film on the substrate into the processing vessel;
a microwave generator for generating a microwave for activating the source gas to produce a plasma;
a waveguide for guiding the microwave generated by the microwave generator into the processing vessel; and
a flat antenna member provided with a plurality of slots formed therein in a circumferential arrangement;
**characterized in that** a plasma producing space extending between source gas supply openings and a surface of the substrate has an electron temperature of 3 eV or below in terms of mean square velocity and an electron density of 5×10¹¹ electrons per cubic centimeter or above.

10. The plasma-assisted deposition system according to claim 9, wherein the slots have a length between half the wavelength of the microwave at the side of the waveguide with respect to a part of the flat antenna member and half the wavelength of the microwave at the side of the plasma producing space with respect to a part of the flat antenna member.

11. The plasma-assisted deposition system according to claim 10, wherein the plurality of slots are arranged on concentric circles having their centers at the center of the flat antenna member or on a spiral around the center of the flat antenna member.

12. The plasma-assisted deposition system according to any one of claims 9 to 11, wherein the microwave radiated from the flat antenna member is a circularly polarized wave or a linearly polarized wave.

13. The plasma-assisted deposition system according to any one of claims 9 to 12, wherein the insulating film to be deposited on the substrate is a fluorine-containing carbon film.

14. The plasma-assisted deposition system according to claim 13, wherein the source gas is C₅F₈ gas.
